# EUROPEAN PATENT APPLICATION

(11) **EP 2 624 300 A1**
(43) Date of publication of application: **07.08.2013**
(21) Application number: 13151070.3
(22) Date of filing: 11.01.2013
(51) Int. Cl.: H01L 27/32

(54) **Display apparatus, display panel, and display method**

(30) Priority: 31.01.2012 KR 20120010088
(71) Applicant: Samsung Electronics Co., Ltd., Gyeonggi-do 443-742 (KR)
(72) Inventor: Yun, Sang-un, Seoul (KR); Cho, Bong-hwan, Gyeonggi-do (KR); Sung, Jun-ho, Seoul (KR)
(74) Representative: Tindall, Adam

(57) **Abstract**

A display apparatus, a display panel, and a display method are provided. The display apparatus includes: a first panel which displays an object by using a self-emission device formed of a transparent material; a second panel which is disposed on a back surface of the first panel; and a controller which switches a state of the second panel to one of a transparent state and an opaque state.

## Description

### CROSS-REFERENCE TO RELATED APPLICATION(S)

This application claims priority under 35 U.S.C. § 119 from Korean Patent Application No. 10-2012-0010088, filed on January 31, 2012, in the Korean Intellectual Property Office, the disclosure of which is incorporated herein by reference in its entirety.

### BACKGROUND

### 1. Field

The present general inventive concept generally relates to a display apparatus, a display panel, and a display method, and more particularly, to a transparent display apparatus which can display a clear image, a display panel therefor, and a display method to be performed by using the display apparatus and/or the display panel.

### 2. Description of the Related Art

A transparent display refers to a display which has predetermined transmissivity and thus shows a background of a screen. The transparent display may be applied to a building, windows of a vehicle, and/or a show window of a shopping center, and thus may provide advertisement, information, and/or original function of a display. Further, the transparent display typically has an outstanding design and thus satisfies a sensitivity quality of a consumer. Therefore, the transparent display may receive attention.

However, if a transparent display apparatus transmits image information, definition and contrast problems may occur. In particular, if the transparent display apparatus transmits complicated information or displays an image requiring high definition and contrast, such as, for example, a movie or a television (TV) program for viewing, light is incident from a back surface of the transparent display apparatus due to a transparency of the transparent display apparatus. Therefore, a definition of the image may be reduced, and the contrast may also be reduced. Accordingly, the transparent display apparatus has a limitation in being used to view a movie or a TV program.

### SUMMARY

Exemplary embodiments address at least the above problems and/or disadvantages and other disadvantages not described above. Further, the exemplary embodiments are not required to overcome the disadvantages described above, and an exemplary embodiment may not overcome any of the problems described above.

The exemplary embodiments provide a transparent display apparatus which can provide a clear image, a display panel for use in conjunction with the transparent display apparatus, and a display method to be performed by the display apparatus and/or the display panel.

According to an aspect of the exemplary embodiments, there is provided a display apparatus including: a first panel which displays an object by using a self-emission element formed of at least one transparent material; a second panel which is disposed on a back surface of the first panel; and a controller which switches at least one state of the second panel to one of a transparent state and an opaque state.

The second panel may be divided into a plurality of areas, and wherein the controller may switch a respective state of each of the plurality of areas of the second panel to one of the transparent state and the opaque state.

The display apparatus may further include: an image processor which forms an image frame comprising a text and an image. The controller may control the first panel to display the image frame; determine a first area from among the plurality of areas of the second panel which corresponds to the text of the image frame and a second area from among the plurality of areas of the second panel which corresponds to the image of the image frame, and control the second panel to switch the state of the first area to the opaque state and switch the state of the second area to the opaque state.

The display apparatus may further include: an input unit which receives a content play command; a receiver which, if the content play command is received, receives at least one content which corresponds to the received command; and an image processor which processes the received at least one content to form an image frame. When the content play command is received, the controller may control the first panel to display the formed image frame, switch the at least one state of the second panel to the opaque state, and, when a content play resulting from an execution of the received content play command is ended, switch the at least one state of the second panel to the transparent state.

The self-emission element may include an organic light-emitting diode (OLED). The first panel may display the object by using the OLED. The second panel may include a polymer dispersed liquid crystal (PDLC).

According to another aspect of the exemplary embodiments, there is provided a display panel including: a first panel which includes a self-emission element formed of at least one transparent material; and a second panel which is disposed on a back surface of the first panel and which has at least one state which is switchable between one of a transparent state and an opaque state.

The second panel may be divided into a plurality of areas, and a respective state of each of the plurality of areas of the second panel may be switchable between the transparent state and the opaque state.

According to another aspect of the exemplary embodiments, there is provided a display method of a display apparatus. The display method may include: displaying an image frame on a first panel of the display apparatus, the first panel including a self-emission element formed of at least one transparent material; and switching at least one state of a second panel, which is disposed on a back surface of the first panel in the display apparatus, to one of a transparent state and an opaque state.

The second panel may be divided into a plurality of areas, and a respective state of each of the plurality of areas of the second panel may be switchable between the transparent state and the opaque state.

When the image frame comprises a text and an image, the method may further include switching the state of a first area from among the plurality of areas of the second panel which corresponds to the text of the image frame to the opaque state, and switching the state of a second area from among the plurality of areas of the second panel which corresponds to the image of the image frame to the opaque state.

The switching of the at least one state of the second panel to one of the transparent state and the opaque state may include: when a content play command is received and an image frame corresponding to the received content play command is displayed on the first panel, switching the at least one state of the second panel to the opaque state; and when a content play resulting from an execution of the received content play command is ended, switching the at least one state of the second panel to the transparent state.

The self-emission element may include an OLED. The second panel may include a PDLC. Further, a non-transitory computer readable recording medium having recorded thereon instructions for causing a computer to execute any of the methods described above may additionally be provided.

Therefore, a transparent display apparatus may also display a clear image.

### BRIEF DESCRIPTION OF THE DRAWINGS

The above and/or other aspects will be more apparent by describing certain exemplary embodiments with reference to the accompanying drawings, in which:

FIG. 1 is a concept view illustrating a function of a display apparatus, according to an exemplary embodiment of the present general inventive concept;

FIG. 2 is a block diagram illustrating a structure of a display apparatus, according to an exemplary embodiment of the present general inventive concept;

FIG. 3 is a block diagram illustrating a circuit structure of a first panel of FIG. 2;

FIG. 4 is a circuit diagram illustrating a pixel area of the first panel of FIG. 2;

FIG. 5 is a referential view illustrating a definition of an image displayed on the first panel according to a state of a second panel;

FIG. 6 is a referential view illustrating a process for adjusting respective transparencies of corresponding areas of the second panel, according to another exemplary embodiment of the present general inventive concept;

FIG. 7 is a block diagram illustrating a structure of a display panel, according to an exemplary embodiment of the present general inventive concept;

FIG. 8 is a flowchart illustrating a display method, according to an exemplary embodiment of the present general inventive concept;

FIG. 9 is a flowchart illustrating a method for adjusting and displaying respective transparencies of corresponding areas of the second panel, according to another exemplary embodiment of the present general inventive concept;

FIG. 10 is a flowchart illustrating a display method for displaying an image frame including a text and an image, according to another exemplary embodiment of the present general inventive concept; and

FIG. 11 is a flowchart illustrating a display method for switching a state of the second panel to an opaque state if a content play command is received, according to another exemplary embodiment of the present general inventive concept.

### DETAILED DESCRIPTION OF THE EXEMPLARY EMBODIMENTS

Exemplary embodiments are described in greater detail with reference to the accompanying drawings.

In the following description, the same drawing reference numerals are used for the same elements even in different drawings. The matters defined in the description, such as detailed construction and elements, are provided to assist in a comprehensive understanding of the exemplary embodiments. Thus, it is apparent that the exemplary embodiments can be carried out without those specifically defined matters. In addition, well-known functions or constructions are not described in detail, because they would obscure the exemplary embodiments with unnecessary detail.

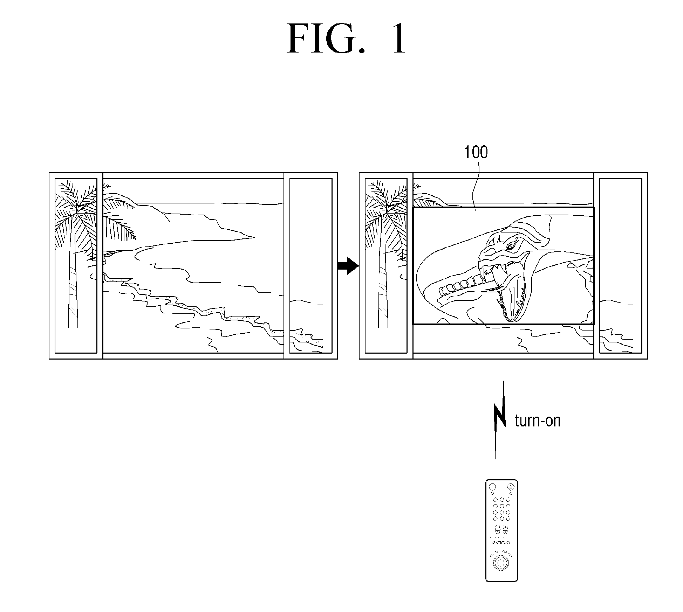

FIG. 1 is a concept view illustrating a function of a display apparatus 100, according to an exemplary embodiment of the present general inventive concept.

The display apparatus 100 is installed at a window as shown in FIG. 1 to transmit light when being turned off, so that a user sees an object on a back surface of the display apparatus 100. If the display apparatus 100 is turned on, the display apparatus 100 displays an image on a screen, and the user views the displayed image. In particular, the image displayed on the screen may have a predetermined transparency which is configured to transmit an image of the object on the back surface of the display apparatus 100. The display apparatus 100 may primarily transmit simple information or provide an advertisement, or may be used for an aesthetic purpose. However, a contrast of a transparent image may be lowered due to an intervention of outdoor light, and the transparent image may not be appropriate to perform an original purpose of the display apparatus 100, such as, for example, viewing of a movie or a television (TV) program. Therefore, the display apparatus 100 is configured to display a clear image, which does not have an opaque image, e.g., an intervention of backlight, on the screen. In particular, even if the user turns on the display apparatus 100 when the user is admiring the scenery outside the window as shown in FIG. l, the user is able to view the clear image. The display apparatus 100 having the above-described effect will now be described.

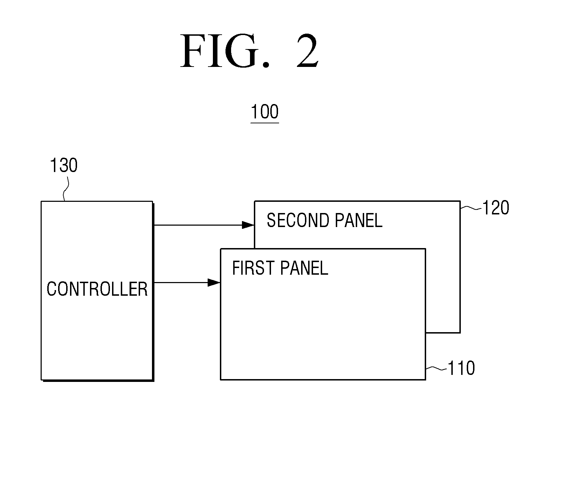

FIG. 2 is a block diagram illustrating a whole structure of the display apparatus 100, according to an exemplary embodiment of the present general inventive concept.

Referring to FIG. 2, the display apparatus 100 includes first panel 110 and second panel 120 which provide displays, and a controller 130 which controls each of the first panel 110 and the second panel 120.

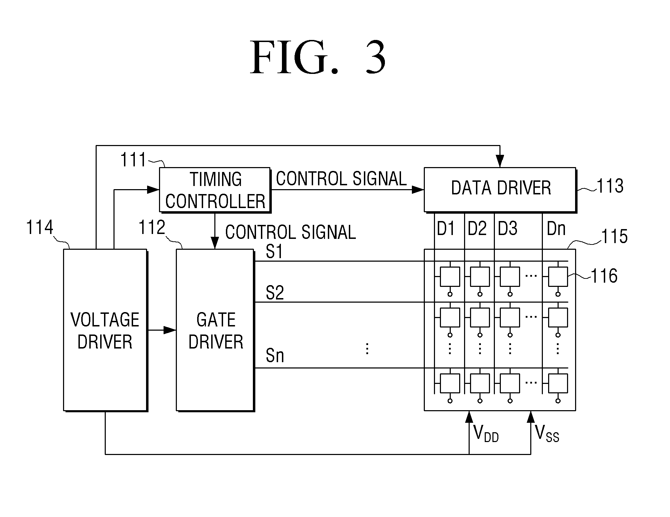

The first panel 110 may include a self-emission device which displays an image and is formed of at least one transparent material. In particular, because the first panel 110 is formed of the at least one transparent material, the first panel 110 transmits light emitted from a back surface of the display apparatus 100, so that a user located in front of the display apparatus 100 sees an image of an object located on the back surface of the display apparatus 100. Further, because the first panel 110 includes the self-emission device, if a voltage is applied, the first panel self-emits light and adjusts the voltage to realize a color. For this purpose, the first panel 110 includes a timing controller 111, a gate driver 112, a data driver 113, a voltage driver 114, and a display panel 115 as shown in FIG. 3.

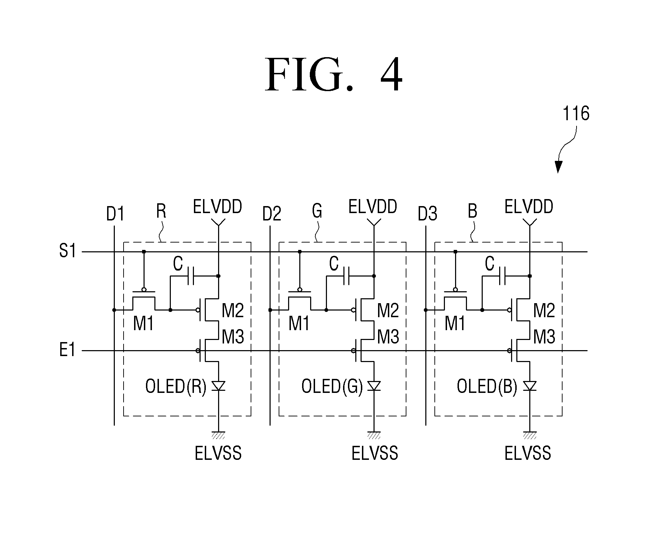

A structure of the first panel 110 will now be described with reference to FIGS. 3 and 4.

FIG. 3 is a block diagram illustrating a circuit structure of the first panel 110 of FIG. 2, and FIG. 4 is a circuit diagram illustrating a pixel area of the first panel 110 of FIG. 2.

The timing controller 111 receives a clock signal DCLK, a horizontal sync signal Hsync, a vertical sync signal Vsync, and any other timing-related signals, which are appropriate for a resolution of the display apparatus 100, from an external source, and uses these signals to generate a gate control signal (e.g., a scanning control signal) and a data control signal (e.g., a data signal), and rearranges received red (R), green (G), and blue (B) data to provide the rearranged R, G, and B data to the data driver 113.

The timing controller 111 may generate a gate shift clock (GSC), a gate output enable (GOE), a gate start pulse (GSP), and any other gate-related outputs in relation to the gate control signal. In particular, the GSC is a signal which is used to determine a time when a thin film transistor (TFT) connected to a light-emitting device is turned on/off, the GOE is a signal which is used to control an output of the gate driver 112, and the GSP is a signal which is used to signal a first driving line of a screen from one vertical sync signal.

The timing controller 111 may generate a source sampling clock (SSC), a source output enable (SOE), a source start pulse (SSP), and any other data control-related outputs in relation to the data control signal. In particular, the SSC is used as a sampling clock which is used to latch data in the data driver 113 and which determines a driving frequency of a data drive integrated circuit (IC). The SOE is used to transmit the data latched by the SSC to the display panel 115. The SSP is a signal which is used to signal a start of latching or sampling of data for a first vertical synchronization period.

The gate driver 112 generates a scanning signal and is connected to the display panel 115 via scanning lines S1, S2, S3, ..., and Sn. The gate driver 112 receives a gate on/off voltage Vgh/Vgl from the voltage driver 114 and applies the gate on/off voltage Vgh/Vgl to the display panel 115 in accordance with the gate control signal generated by the timing controller 111. The gate on voltage Vgh is applied sequentially to each of the first through N^{th} gate lines GL1, GL2, GL3, ... GLn to realize a unit frame image on the display panel 115

The data driver 113 generates a data signal and is connected to the display panel 115 via data lines D1, D2, D3, ..., and Dn. The data driver 113 inputs image data, including RGB data, into the display panel 115 in accordance with the data control signal generated by the timing controller 111. The data driver 113 converts serial RGB image data, which is received from the timing controller 111, into parallel RGB image data, and converts digital data into an analog voltage to provide image data corresponding to one horizontal line to the display panel 115. This process is performed sequentially with respect to horizontal lines.

The voltage driver 114 generates driving voltages and respectively transmits the driving voltages to the display panel 115, the gate driver 112, the data driver 113, and the timing controller 111. In particular, the voltage driver 114 receives commercial power, such as, for example, an alternating current (AC) voltage of 110V or 220V, from an external source, generates a power supply voltage VDD which is required for the display panel 115, and provides the power supply voltage VDD to the display panel 115, or provides a ground voltage VSS to the display panel 115. The voltage driver 114 may generate the gate on voltage Vgh and provide the gate on voltage Vgh to the gate driver 112. For this purpose, the voltage driver 114 may include a plurality of voltage driving modules (not shown) which operate independently of each other. In particular, each of the plurality of voltage driving modules may operate to provide a different respective voltage under control of the controller 130. Further, the controller 130 may control the voltage driver 114 so that the plurality of voltage driving modules provide the different voltages based on preset information. For example, the plurality of voltage driving modules may provide different types of first voltages and second voltages set to default based on the preset information, under control of the controller 130.

According to an exemplary embodiment, the voltage driver 114 may include a plurality of voltage driving modules, each of which respectively corresponds to a respective one of a plurality of areas of the display panel 115. In this case, the controller 130 may control the plurality of voltage driving modules to provide different types of first voltages, e.g., voltages ELVDD, based on respective screen information or respective input image information relating to each respective one of the plurality of areas. In particular, the controller 130 may control intensities of the voltages ELVDD by using an image signal which is inputted into the data driver 113. More particularly, the screen information may be at least one of luminance information and a gradation information relating to an input image.

The controller 130 according to the present exemplary embodiment is an element installed separately from the timing controller 111, but this is only an exemplary embodiment. Therefore, the controller 130 may be realized as a function of the timing controller 111.

The display panel 115 may include a plurality of gate lines GL1, GL2, GL3, ..., GLn and a plurality of data lines DL1, DL2, DL3, ... , DLn. The gate lines GL1. GL2, GL3, ..., GLn cross the data lines DL1 and DLn to define pixel areas 116, and R, G, and B light-emitting devices, such as, for example, organic light-emitting diodes (OLEDs), are formed in the pixel areas 116. A switching device, e.g., a TFT, is formed in an area of each of the pixel areas 116, e.g., at a respective corner of each of the respective pixel areas 116. When the TFTs are turned on, gradation voltages are provided from the data driver 113 to the R, G, and B light-emitting devices. In particular, each of the R, G, and B light-emitting devices provides light in response to a respective amount of current provided based on the corresponding gradation voltages. If a large amount of current is provided, each of the R, G, and B light-emitting devices provides a large amount of light corresponding to the large amount of current.

The R, G, and B pixel areas 116 will now be described in more detail with reference to FIG. 4. The display panel 115 may include switching devices M1, M2, and M3. The switching devices M1 operate according to scan signal S1, which corresponds to the gate on voltage Vgh. The switching devices M2 output a current based on a pixel value which includes a changed high gradation value provided to the data lines DL1, DL2, DL3, ..., DLn. The switching devices M3 adjust an amount of a current provided to the R, G, and B light-emitting devices from the switch devices M2 based on a control signal received from the timing controller 111. The switching devices M3 are connected to the respective OLEDs to supply a current to the OLEDs. In particular, the OLEDs refer to displays which self-emit light by using an electric field light-emitting principle if a current flows in fluorescent or phosphorescent organic thin films. Anodes of the OLEDs are connected to pixel circuits, and cathodes of the OLEDs are connected to second power ELVSS. The OLEDs generate light having predetermined luminance in response to current provided from the pixel circuits. In particular, gate electrodes of the switching devices are connected to a scan line S, and first electrodes are connected to data lines D1.

As described above, the display panel 115 may be an active matrix organic light-emitting diode (AM-OLED) panel. However, this is only an exemplary embodiment, and thus the present general inventive concept does not exclude a passive matrix OLED (PM-OLED) in which one line simultaneously emit and drive light beams.

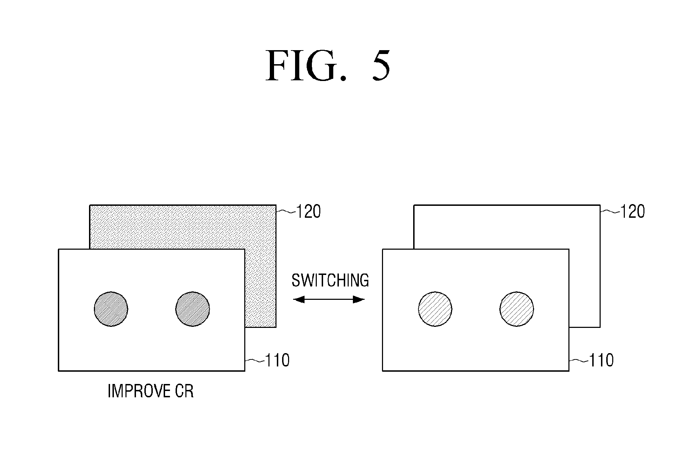

The second panel 120 is disposed on a back surface of the first panel 110, and blocks or transmits light from the back surface of the display apparatus 100 by using an electronic or mechanical method. In particular, the second panel 120 may be switched to a transparent state, similar to that of the first panel 110, in order to transmit natural light incident from the back surface of the display apparatus 100 under control of the controller 130. Alternatively, the second panel 120 may be switched to an opaque state in order to block the light incident from the back surface of the display apparatus 100 under control of the controller 130. If the light is incident from the back surface of the display apparatus 100, the display apparatus 100 is switched to a transparent state, and the first panel 110 displays a transparent image. If the light is blocked from the back surface of the display apparatus 100, the display apparatus 100 is switched to an opaque state, and the image displayed on the first panel 110 becomes an opaque image on which an image is not formed on the back surface of the display apparatus 100 (refer to FIG. 5).

According to another exemplary embodiment, the second panel 120 may be realized as a polymer dispersed liquid crystal (PDLC). The PDLC refers to a display method by which minute liquid crystal drops are formed in a parent of a polymer material and react to a voltage applied from an external source to scatter or absorb light in order to display information. In particular, on a PDLC panel, a polymer material hardened by ultraviolet rays or heat is mixed with liquid crystals and then injected into liquid crystal specimens. If heat is applied to the liquid crystal specimens, or if the liquid crystal specimens are exposed to ultraviolet rays, the liquid crystal specimens are hardened, and liquid crystal drops are formed in a polymer network. If an external voltage is not applied, liquid crystals in the liquid crystal drops are arranged in an arbitrary direction, and light is irregularly scattered. In an exemplary embodiment, the light is irregularly scattered due to a difference between an effective refractive index of a liquid crystal and a refractive index of polymer. If an external voltage is applied, the liquid crystals in the liquid crystal drops are arranged in accordance with a direction of the external voltage. Therefore, in this state, liquid crystal molecules are arranged in one direction to transmit light, and the liquid crystal specimens are changed into a transparent state. The PDLC panel may be adjusted from a complete transparent state to a transparent state having a relative transparency of between 1% and 100%, in accordance with an intensity of a voltage applied to the PDLC panel.

Therefore, if a power is not applied to the second panel 120, which includes the PDLC, a refractive index of a polymer molecule of the second panel 120 is different from a refractive index of a liquid crystal index. As a result, light varies according to a progress path and thus is scattered between the polymer molecule and the liquid crystal molecule, thereby causing the second panel 120 to appear opaque or semi-transparent. If the external voltage is applied to the second panel 120, the refractive index of the polymer molecule forming the second panel is equal to the refractive index of the liquid crystal molecule. Therefore, light incident perpendicular to a plane of the second panel is not scattered, but is instead transmitted. As a result, if the external voltage is applied, the second panel 120 appears transparent. Further, the intensity of the voltage applied to the second panel 120 may be changed to adjust a degree of transparency of the second panel 120.

A transparent state or an opaque state of the second panel 120 is set under control of the controller 130. In particular, the controller 130 controls an overall operation of the display apparatus 100, and more particularly, adjusts a degree of transparency of the second panel 120 to adjust a corresponding degree of transparency of an image displayed on the second panel 110, based on a purpose of the display apparatus 100. In more detail, as described above, the controller 130 applies a voltage to the second panel 120 to make the refractive index of the polymer molecule forming the second panel 120 equal to the refractive index of the liquid crystal molecule, in order to change the state of the second panel 120 into the transparent state. If the controller 130 controls the second panel 120 to cause the state to change to the transparent state, the second panel 120 transmits light through the back surface of the display apparatus 100. Therefore, an image displayed on the first panel 110 in the transparent state becomes a transparent image. This transparent image may be used to show an anesthetic effect and/or to display useful information on a multipurpose electronic apparatus. For example, if a part of a door of a refrigerator is formed, a transparent image may display state information relating to contents of the refrigerator or a temperature of the refrigerator. Further, the transparent image may be used to display an operation state of a washer or a microwave on a respective door of the corresponding device. However, contrast or definition of the transparent image may be lowered due to an intervention of light, and thus the transparent image may be inappropriate for a display apparatus for viewing a TV program or a movie, or for transmitting complicated image information. Therefore, the display apparatus 100 is more suitable to display a clear image having no opaque image, such as, for example, an intervention backlight, on the screen.

For this purpose, the controller 130 may adjust a state of the second panel 120 to the opaque state to block light from the back surface of the display apparatus 100. As described above, the controller 130 does not apply power to the second panel 120 or reduces an amount of power applied to the panel 120 to make the refractive index of the polymer molecule of the second panel 120 different from the refractive index of the liquid crystal molecule in order to scatter light between the polymer molecule and the liquid crystal molecule, thereby controlling the second panel 120 to be opaque or semi-transparent. In particular, the first panel 110 may display an image having complete definition and contrast. Therefore, as shown in FIG. 1, the user may view a completely clear image through the display apparatus 100 when outdoor light is blocked.

According to various exemplary embodiments of the present general inventive concept, the second panel 120 may be realized by using various methods. The second plane 120 may be realized according to an electrochromic (EC) method, a liquid crystal (LC) method, or a suspended particle device (SPC) method as an active method. The second panel 120 may also be realized according to a photochromic method or a thermochromic method as a passive method. These techniques may be widely used to realize e-paper and for a general-purpose display apparatus. In particular, all types of techniques for blocking or allowing an incidence of light from a back surface of the first panel 110 having transparency may be included in claims relating to the present general inventive concept.

The second panel 120 may be realized according to a mechanical method. In particular, the second panel 120 may be a blind which may transmit or block light. The controller 130 may open the blind to display a transparent image through the first panel 110, or may close the blind to make an image of the first panel opaque.

The second panel 120 may be divided into a plurality of areas, each of which has a state which may be switched to a transparent state or an opaque state. The controller 130 may also control the second panel 120 to make a part of the second panel 120 opaque in order to transparently display the image of the first panel 110. In particular, the second panel 120 may be divided into n areas, and each of the n areas may be individually controlled. If the second panel 120 is realized as a PDLC, the controller 130 may respectively apply power sources having different intensities to the respective areas of the second panel 120 to adjust a scattered degree of light in each of the respective areas in order to make corresponding transparencies of the respective areas different from one another. Therefore, the second panel 120 may display an image having different respective transparencies in the corresponding areas thereof to be appropriate for the purpose of the display apparatus 100.

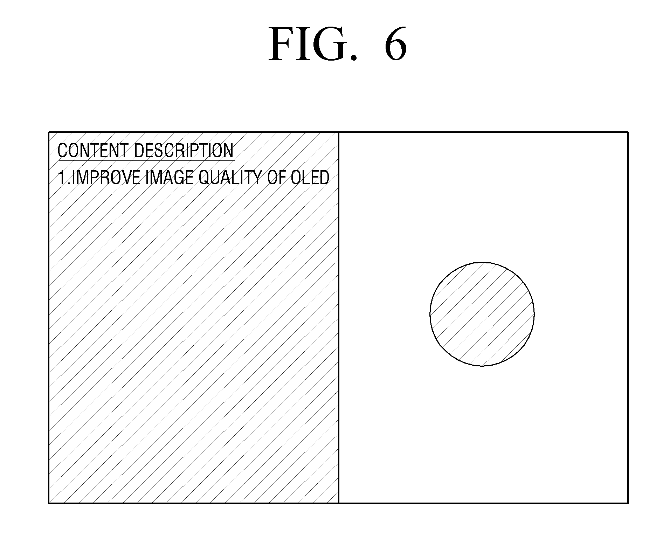

According to another exemplary embodiment, as shown in FIG. 6, the second panel 120 may be controlled to switch a state of an area of the second panel 120, which corresponds to a text part of an image frame displayed on the first panel 110, into an opaque state and switch a state of an area of the second panel 120, which corresponds to an image part of the image frame displayed on the first panel 110, into a transparent state. For this purpose, the display apparatus 100 may further include an image processor (not shown).

The image processor forms an image frame, including a text and an image. In particular, the image processor may form the image frame to display received text data in an area of the first panel 110 which corresponds to a text area of the second panel 120. Further, the image processor may combine and form the image frame to display received image data in an area of the first panel 110 which corresponds to an image area of the second panel 120. If the image frame formed from the combination of the text and the image is received, the controller 130 may control the second panel 120 to make respective degrees of transparency of the areas of the second panel 120 different in order to display the text as an opaque image and the image as a transparent image.

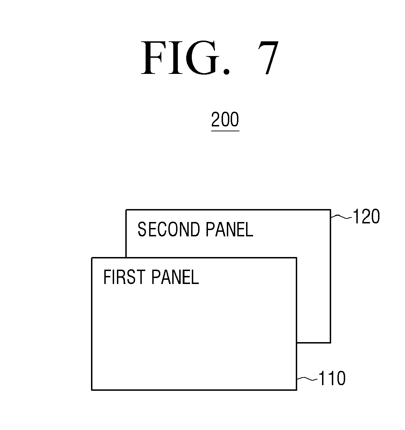

Referring also to FIG. 7, the controller 130 may control the state of the second panel 120 of output unit 200 with respect to transparency and/or opaqueness based on an operation state of the first panel 110. In particular, the controller 130 may analyze the operation state of the first panel 110 to adjust the degree of transparency of the second panel 120 so that the degree of transparency of the second panel 120 is appropriate for an operation purpose of the first panel 110. If an image displayed on the first panel 110 is used to transmit an advertisement, a decoration, or simple information as described above, the controller 130 may set the state of the second panel 120 to the transparent state. However, if the first panel 110 is being used to display an image having high definition and contrast, such as, for example, a TV program or a movie, the controller 130 may set the state of the second panel 120 to the opaque state.

As an example of an operation of the controller 130, if contents are displayed, the controller 130 may control the first panel 110 to display an image frame which includes the contents and to switch the state of the second panel 120 to an opaque state. If playing of the contents is ended, the controller 130 may switch the state of the second panel 120 to a transparent state. For this purpose, the display apparatus 100 may further include an input unit (not shown) which receives a content play command, a receiver (not shown) which receives contents, and an image processor (not shown) which processes the contents to form an image frame.

The input unit is an element which receives a command, such as, for example, a command to play the contents, from an external source. For example, the input unit may be an interface which receives a command signal which is transmitted from a remote controller such as that shown in FIG. 1. The realization of the input unit is not technically limited.

The receiver is an element which receives the contents, and the contents may be transmitted via various routes. For example, the receiver may receive broadcast program contents from a broadcasting state by using a broadcast network, or may receive a content file from a web server by using the Internet. The receiver may receive the contents from any one or more of various types of recording media players which are installed in or connected to the display apparatus 100. The recording media players refer to apparatuses which play contents stored on various types of recording media, such as, for example, a compact disk (CD), a digital video disk (DVD), a hard disk, a blu-ray disk, a memory card, a universal serial bus (USB) memory, or any other suitable type of recording medium.

The image processor processes the received contents to form the image frame. In particular, the image processor performs signal processing with respect to image data included in the contents received from the receiver. For this purpose, the image processor may include a decoder (not shown) which decodes the image data and a scaler (not shown) which upscales or downscales the image data in accordance with a screen size of the output unit 200.

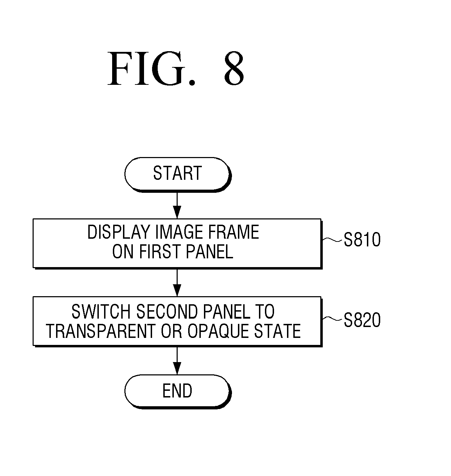

A display method according to various exemplary embodiments of the present general inventive concept will now be described with reference to FIGS. 8, 9, 10, and 11.

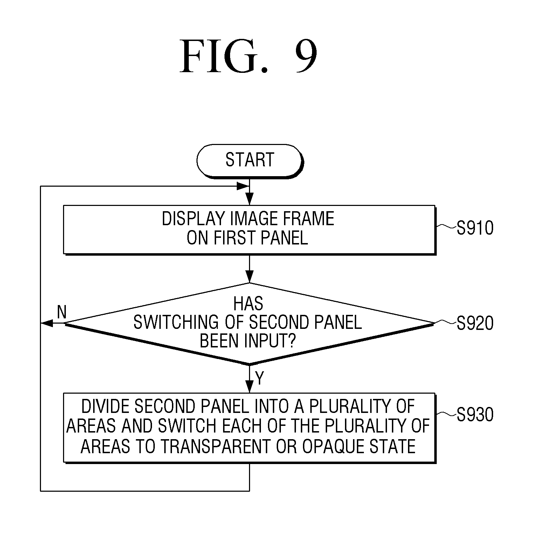

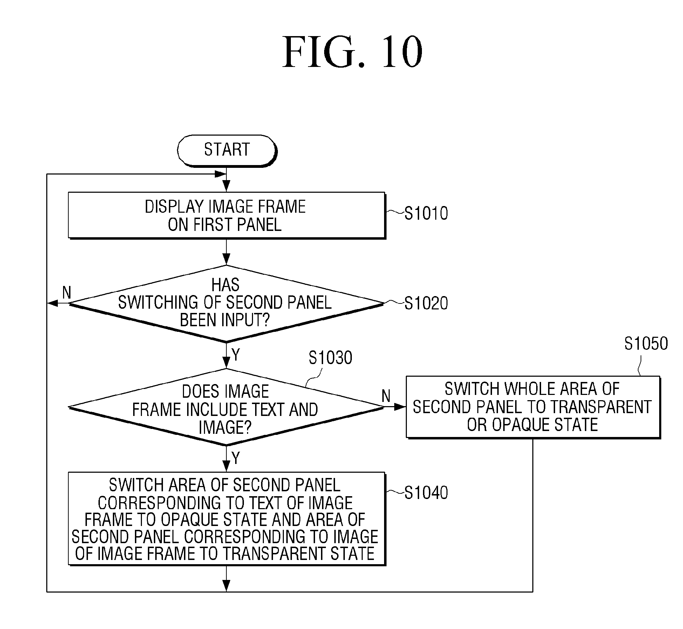

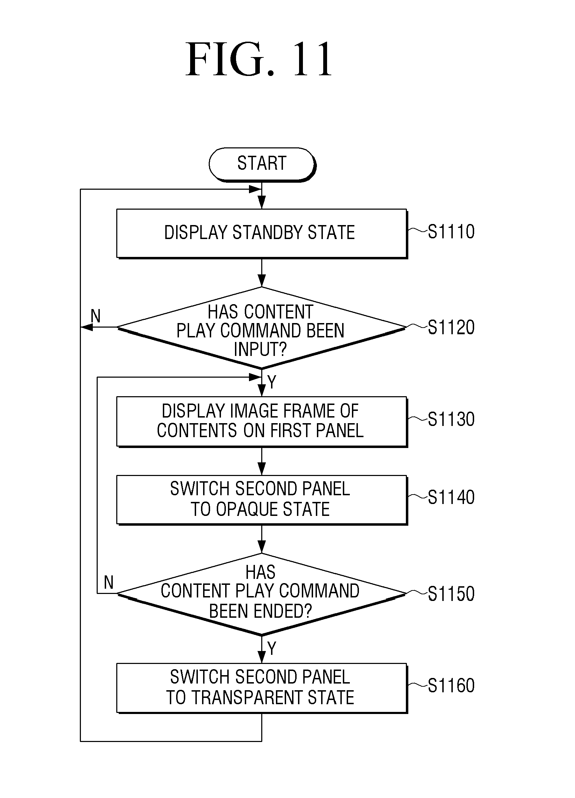

FIG. 8 is a flowchart illustrating a display method, according to an exemplary embodiment of the present general inventive concept. FIG. 9 is a flowchart illustrating a method for adjusting and displaying respective transparencies of corresponding areas of a second panel, according to another exemplary embodiment of the present general inventive concept. FIG. 10 is a flowchart illustrating a display method for displaying an image frame including a text and an image, according to another exemplary embodiment of the present general inventive concept. FIG. 11 is a flowchart illustrating a display method for switching a state of a second panel to an opaque state in accordance with a contents play command, according to another exemplary embodiment of the present general inventive concept.

Referring to FIGS. 8, 9, and 10, in each of operations S810, S910, and S1010, an image frame is displayed on a first pane which includes a self-emission device formed of at least one transparent material. In operation S820, a state of a second panel which is disposed on a back surface of the first panel in a display apparatus is switched to a transparent state or an opaque state.

In operation S920, if a switching input of the second panel is received, a respective state of each of a plurality of areas of the second panel is switched to one of a transparent state and an opaque state in operation S930.

In operation S1020, if a switching input of the second panel is received, the method proceeds to operation 1030. If a determination is made in operation S1030 that the image frame displayed on the first panel includes a text and an image, the state of the area of the second panel corresponding to the text of the image frame is switched to an opaque state, and the state of the area of the second panel corresponding to the image of the image frame is switched to a transparent state in operation S1040. If a determination is made in operation S1030 that the image frame displayed on the first panel does not include both of the text and the image, the state of the whole area of the second panel is switched to one of a transparent state and an opaque state in operation S1050.

Referring to FIG. 11, in operation S1110, a standby state is displayed. In operation S1120, if a content play command has been received, a content image frame is displayed on the first panel in operation S1130, and the state of the second panel is switched to an opaque state in operation S1140. If the content play command is ended in operation S1150, the state of the second panel is switched to a transparent state in operation S1160.

Therefore, the display apparatus 100 may be used as a transparent display apparatus or an opaque display apparatus, in accordance with the purpose of the display. Definition and contrast of the transparent display apparatus may be improved. Accordingly, a multipurpose display is possible.

The foregoing exemplary embodiments and advantages are merely exemplary and are not to be construed as limiting. The present disclosure can be readily applied to other types of apparatuses. Further, the description of the exemplary embodiments is intended to be illustrative, and not to limit the scope of the claims, and many alternatives, modifications, and variations will be apparent to those skilled in the art.

## Claims

1. A display apparatus comprising:
a first panel which displays an object by using a self-emission element formed of transparent material;
a second panel which is disposed on a back surface of the first panel; and
a controller which switches at least one state of the second panel to a transparent state or an opaque state.

2. The display apparatus of claim 1, wherein the second panel is divided into a plurality of areas, and wherein the controller switches a respective state of each of the plurality of areas of the second panel to the transparent state or the opaque state.

3. The display apparatus of claim 2, further comprising:
an image processor which forms an image frame comprising a text and an image,
wherein the controller controls the first panel to display the image frame and controls the second panel to switch the state of an area of the second panel corresponding to the text of the image frame into the opaque state and to switch the state of an area of the second panel corresponding to the image of the image frame into the opaque state.

4. The display apparatus of claim 1, further comprising:
an input unit which receives a content play command;
a receiver which, if the content play command is received, receives at least one content; and
an image processor which processes the received at least one content to form an image frame,
wherein when the content play command is received, the controller controls the first panel to display the image frame, switches the at least one state of the second panel to the opaque state, and, when a content play is ended, switches the at least one state of the second panel to the transparent state.

5. The display apparatus of claim 1, wherein:
the self-emission element is an organic light-emitting diode (OLED);
the first panel displays the object by using the OLED; and
the second panel comprises a polymer dispersed liquid crystal (PDLC).

6. A display panel comprising:
a first panel which comprises a self-emission element formed of transparent material; and
a second panel which is disposed on a back surface of the first panel and which has at least one state which is switchable between one of transparent and opaque states.

7. The display panel of claim 6, wherein the second panel is divided into a plurality of areas, and a respective state of each of the plurality of areas of the second panel is switchable between the transparent state and the opaque state.

8. A display method of a display apparatus, the display method comprising:
displaying an image frame on a first panel comprising a self-emission element formed of transparent material; and
switching at least one state of a second panel, which is disposed on a back surface of the first panel in the display apparatus, to a transparent state or an opaque state.

9. The display method of claim 8, wherein the second panel is divided into a plurality of areas, and wherein a respective state of each of the plurality of areas of the second panel is switchable between the transparent state and the opaque state.

10. The display method of claim 9, wherein when the image frame comprises a text and an image, the state of an area of the second panel corresponding to the text of the image frame is switched to the opaque state, and the state of an area of the second panel corresponding to the image of the image frame is switched to the opaque state.

11. The display method of claim 8, wherein the switching of the at least one state of the second panel to the transparent or opaque state comprises:
when a content play command is received and an image frame is displayed on the first panel, switching the at least one state of the second panel to the opaque state; and
when a content play is ended, switching the at least one state of the second panel to the transparent state.

12. The display method of claim 8, wherein:
the self-emission element is an OLED; and
the second panel comprises a PDLC.
